# EUROPEAN PATENT SPECIFICATION

(11) **EP 1 472 740 B1**
(45) Date of publication and mention of the grant of the patent: **11.03.2009**
(21) Application number: 03731777.3
(22) Date of filing: 15.01.2003
(51) Int. Cl.: H01L 27/146

(54) **IMAGER**
ABBILDUNGSVORRICHTUNG
IMAGEUR

(30) Priority: 24.01.2002 EP 02075295
(43) Date of publication of application: 03.11.2004
(73) Proprietor: Koninklijke Philips Electronics N.V., 5621 BA Eindhoven (NL)
(72) Inventor: KORTHOUT, Alouisius, W., M., NL-5656 AA Eindhoven (NL)
(74) Representative: Damen, Daniel Martijn
(86) International application number: PCT/IB2003/000091
(87) International publication number: WO 2003/063247

(56) References cited:
- EP-A- 0 905 788
- WO-A-01/47021
- WO-A-99/66560
- US-A1- 2001 030 704

## Description

The invention relates to an imager comprising a semiconductor body, a surface of which is provided with image pick-up elements each comprising a photodiode with an anode and a cathode and further comprising a reset transistor with a source zone and a drain zone of a first conductivity type and a gate, which gate is connected to means for applying voltages for turning the transistor on and off and in which one of the source and drain zones is connected to one of the anode and cathode regions of the first conductivity type of the photodiode, of which the other region of the opposite, second conductivity type is connected to a junction point to which a voltage V1 is applied during operation, and in which the other region of the source and drain zones of the transistor is connected to a junction point to which a voltage V2 different from V1 is applied during operation, in which the photodiode is first reset during operation by applying a voltage to the gate, causing the transistor to be turned on, whereafter a further voltage V3 is applied to the gate during a subsequent integration period, causing the transistor to be turned off.

Imagers of this type are generally known and are distinguished from CCD sensors in that they can be manufactured in a CMOS process so that it is possible to integrate electronic circuits on the chip, for example, for driving and/or signal processing.

After resetting the photodiode, it is common practice to maintain the reset transistor in its off-state during the integration period by applying the supply voltage V1 to the gate so that there is no or substantially no conductance via the reset transistor, even when the diode is completely discharged due to absorption of incident radiation.

For a satisfactory operation of imagers, it is important that leakage currents are as small as possible. Since these leakage currents generally vary fairly strongly across the imager matrix, they may lead to a high value of the FPN (fixed pattern noise) or to a high number of "white elements", i.e. elements supplying a maximal signal even upon imaging in the dark.

WO 99/66560 A, WO 01/47021 A and US 2001/030704 A1 disclose imagers at least in part according to the preamble of present claim 1.

Practice has proved that the FPN and/or the number of white elements is fairly high in CMOS imagers of the type described hereinbefore. It is therefore an object of the invention to provide a solution to this problem.

According to the invention, an imager of the type described in the opening paragraph is characterized in that the level of V3 is chosen to be such that |V3 - V2| < |V1 - V2|.

It has surprisingly been found that leakage currents can be considerably reduced by applying a voltage to the gate of the reset transistor during the integration period, which voltage (in the case of a p-channel transistor) is slightly lower than the supply voltage V1 or (in the case of an n-channel transistor) is slightly higher than V1. As will be apparent from the description of the Figures, the deviation of V1 may be chosen to be such that it causes no decrease or only a very small decrease of the maximal signal (white). The invention is based, inter alia, on the recognition that the gate oxide of the reset transistor, whose thickness is determined by the rules of standard CMOS processes, has a thickness of only several nms at which tunnel currents may have a considerable value. After resetting of the diode, such a voltage is applied to the gate of the reset transistor that there is a maximal field across the gate oxide so that tunnel currents run across the gate oxide which are observed as leakage currents in the photodiode during the integration period. With the measure proposed hereinbefore, the field across the gate oxide and hence the quantity of said tunnel current is decreased in a simple and efficient way.

An important embodiment of an imager according to the invention, in which the measure proposed above can be used without or substantially without a decrease of the white-black difference, is characterized in that the region of the first conductivity type of the photodiode is connected to the input of a source follower circuit. Said region of the photodiode may be connected in a directly conducting manner to the source follower. Advantageously, a switch, for example, a transistor may be arranged between the photodiode and the source follower, with which transistor the connection between the photodiode and the source follower can be interrupted after the signal has been applied to the input of the source follower, for example, to be able to read in accordance with the known "correlated double sampling" read method.

Although the invention may also be used to advantage in embodiments in which the reset transistor is of the n-channel type (and in which the cathode of the photodiode is connected to the source of the reset transistor), special advantages are obtained in embodiments of the opposite conductivity type. A further important embodiment of an imager according to the invention is therefore characterized in that the reset transistor is of the p-channel type and has a source in the form of a p-type zone which is connected in a conducting manner to the anode of the photodiode.

These and other aspects of the invention are apparent from and will be elucidated with reference to the embodiments described hereinafter.

In the drawings:
Fig. 1 is a diagram of a CMOS imager of the type to which the invention relates;
Fig. 2 is an electric circuit diagram of an element of the imager shown in Fig. 1;
Fig. 3 is a cross-section of the reset transistor and the photodiode of the pick-up element of Fig. 2;
Fig. 4 shows a histogram of the dark current for various values of the reset voltage.

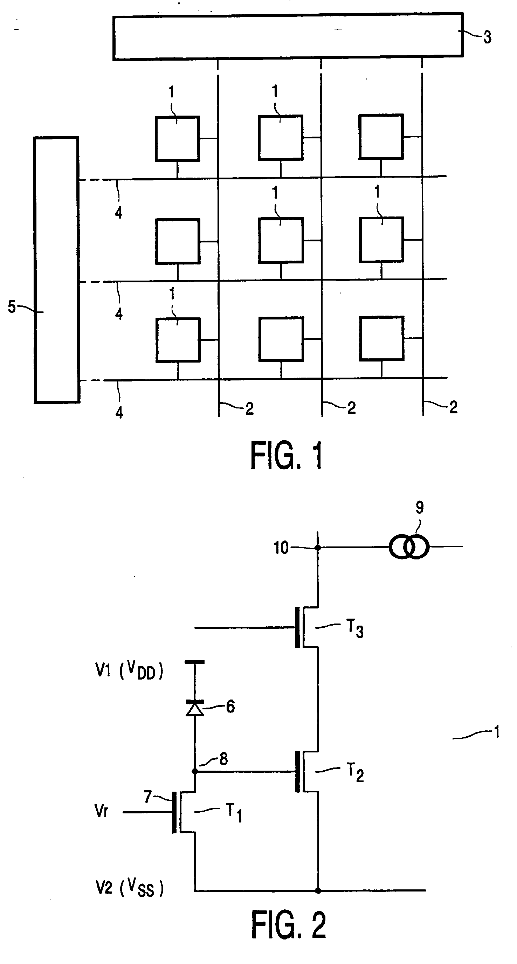

The imager shown in Fig. 1 comprises a number of pick-up elements 1 arranged in a two-dimensional pattern of horizontal rows and vertical columns. The cells are connected in the vertical direction to read lines 2 which pass on the signals to be read to a read member 3. In the horizontal direction, the cells are connected to selection lines 4 via which the selection signal can be sent to a row to be read, which is selected by addressing means 5. In the horizontal direction, the cells may also be connected by horizontal reset lines (not shown).

Fig. 2 is the circuit diagram of a pick-up element or cell 1. The radiation to be measured is detected in a photodiode 6 whose cathode is connected to a junction point to which a fixed voltage V1, in this example the power supply voltage VDD, is applied. The anode of the photodiode is connected to the source of a reset transistor T1 whose drain is connected to a junction point to which a fixed voltage V2, in this example the voltage Vss, is applied. Voltages Vr for turning the transistor T1 on and off are applied to the gate 7 of the reset transistor T1. Dependent on the quantity of detected radiation, the voltage at junction point 8 changes, which change is amplified in this example in the cell by a source follower comprising a transistor T2 whose gate is connected to junction point 8, the drain is connected to V2 and the source is connected to the drain of a selection transistor T3 whose gate is connected to one of the selection lines 4 in the diagram shown in Fig. 1, while the source of the selection transistor T3 is connected via a load, shown by way of the current source 9 in the Figure to a positive voltage, for example V1. The junction point 10 between the source of T3 and load 9 is connected to one of the read lines 2 in Fig. 1.

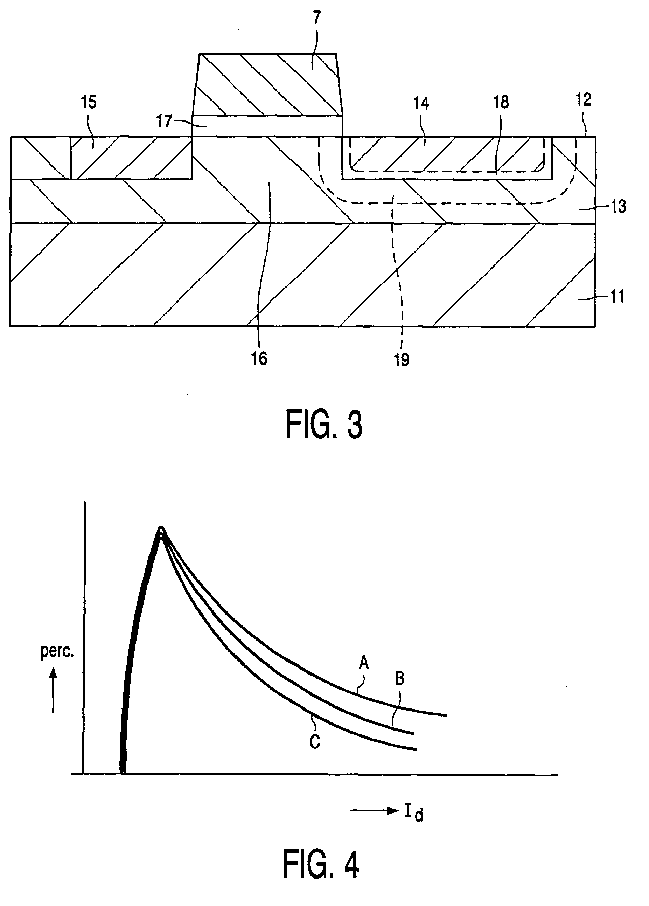

Fig. 3 is a cross-section of the diode 6 and the reset transistor T1. In this embodiment, the device comprises a p-type silicon substrate 11 which is provided with an n well 13 on its surface 12. The source and drain zones of the reset transistor which is of the p-channel type in this example, as well as the transistors T2 and T3 are constituted by the p-type zones 14 and 15, respectively, provided in the n well 13. The zones 14 and 15 are mutually separated by the channel region 16 which is insulated from the gate 7 by the gate dielectric 17. In a specific embodiment, the dielectric 17 is constituted by a layer of silicon oxide having a thickness of 7.5 nm.

During operation, the voltage V1 i.e. Vdd in this example with a value of, for example, 3.3 V, is applied to the well 13, while the voltage V2 (Vss) having a value of, for example, 1.2 V is applied to the drain 15. In this embodiment, the p-type source zone 14 completely coincides with the anode of the photodiode 6; it will, however, be evident that these zones may be formed in other embodiments by zones which are laterally separated from each other and are electrically interconnected by a part of the common wiring (not shown). The diode is first reset by turning on the transistor T1 by applying a low voltage of, for example, 0 V to the gate 7 so that the anode of the photodiode is brought to a voltage which is equal or substantially equal to 1.2 V. Subsequently, the transistor is turned off by applying a high voltage to the gate. The pn junction 18 of the anode is now reverse-biased so that a depletion zone 19 shown by way of broken lines in the Figure is formed around the pn junction. During the subsequent integration period, the diode can be discharged entirely or partly, dependent on the light intensity of the incident radiation, at which the voltage across the p-type zone 14 increases again. The voltage across the zone 14 cannot increase any further than the threshold voltage of the reset transistor T1, because T1 is turned on again when there is a further increase. It should be noted that "weak inversion" effects are not taken into account here so that the transistor may already be turned on to a very small extent at a gate voltage which is slightly lower than the threshold voltage. For reading the cell, a low voltage of, for example, 0 V is applied via the associated selection line 4 to the gate of the selection transistor T3 so that a current can flow through the source follower T2, T3, 9 and an output signal on the associated bit line 2 can be detected.

To obtain a signal which is as large as possible, it is important to prevent loss of electric charge at higher intensities of the incident radiation. It is therefore common practice to apply the voltage Vdd to the gate 7 of the (p-channel) reset transistor T1 during the integration period. However, practice proves that, in this mode of operation, large leakage currents occur in a relatively large number of cells of the matrix, causing the photodiodes to be discharged. Such leakage currents may be measured, for example, by defining the dark current in each cell during a complete integration period. Fig. 4 shows a histogram of the dark current for different values of the reset voltage. The dark current is plotted on the horizontal axis (in arbitrary units); the percentage of pixels is plotted on the vertical axis. Curve A shows the situation when the voltage Vdd is applied to the gate of the reset transistor during the integration period; curves B and C show the distribution of the dark current at lower voltages across the gate of the reset transistor. The graph clearly shows that the dark current decreases at lower voltages across the gate of the reset transistor during the integration period.

At a too low voltage across the gate of the reset transistor, the reset transistor will be turned on again in the case of an increasing potential of the anode of the photodiode due to absorption of radiation, so that the voltage across the anode (source of the reset transistor) will no longer increase any further. It is therefore desirable not to decrease the voltage across the gate of the reset transistor to a too large extent so as to prevent too much limitation of the dynamic range of the cell.

In a realized embodiment, the voltage V1 (Vdd) was 3.3 V, while V2 was equal to 1.2 V. Without using the measure according to the invention, the drive signals across the gate of the reset transistor had a value of 0 V for turning on the transistor and 3.3 V for turning off the transistor. In this situation, the integration therefore starts at a voltage of 3.3 - 1.2 = 2.1 V across the gate oxide of the transistor. For the dark scenes in the image to be picked up, this voltage remains substantially constant because the blocking voltage across the photodiode is not interrupted or only hardly interrupted so that a relatively large tunnel current can flow across the gate oxide, which tunnel current may considerably contribute to the dark current. For determining a suitable value of Vr during the integration, it is assumed that the maximum value of the output signal at output 10 may have the value Vdd, see Fig. 2. The maximally usable value for the voltage across the gate of T2 is then Vdd - Vgs (of T2) = Vdd - Vth - Von, in which Vth and Von are the threshold voltage of T2 and the source-gate voltage in T2 above the threshold voltage, respectively. The high level of Vr may be equal to or slightly lower than this value without a decrease of the maximum signal at output 10. The high value of Vr is preferably chosen to be slightly higher than Vdd - 2Vth - Von so as to prevent linearity problems of the signal due to weak inversion in T1. At values of Vth and Von of 0.6 V and 0.2 V, respectively, the reset drive voltage may, however, be reduced without any problem to 3.3 - 0.6 - 0.2 = 2.5 V so that the voltage across the gate oxide of T1 is reduced to 1.3 V. At this value of the reset drive voltage, the dark current appears to be reduced to a strong extent in many cells, as is indicated by curves B and C in Fig. 4.

It will be evident that the invention is not limited to the embodiment described above, but that many variations within the scope of the invention can be conceived by those skilled in the art without departing from the invention as defined by the appended claims. For example, the conductivity types of the various components may be reversed. Alternatively, different amplifiers may be used instead of the amplifier described hereinbefore. The signals generated in the photodiodes may also be amplified in an output amplifier which is common for the cells, instead of in the cell itself.

## Claims

1. An imager comprising a semiconductor body, a surface of which is provided with image pick-up elements each comprising a photodiode with an anode and a cathode and further comprising a reset transistor with a source zone and a drain zone of a first conductivity type and a gate, which gate is connected to means for applying voltages for turning the transistor on and off and in which one of the source and drain zones is connected to one of the anode and cathode regions of the first conductivity type of the photodiode, of which the other region of the opposite, second conductivity type is connected to a junction point to which a voltage V1 is applied during operation, and in which the other region of the source and drain zones of the transistor is connected to a junction point to which a voltage V2 different from V1 is applied during operation, in which the photodiode is first reset during operation by applying a voltage to the gate, causing the transistor to be turned on, whereafter a further voltage V3 is applied to the gate during a subsequent integration period, causing the transistor to be turned off, **characterized in that** the level of V3 is chosen to be such that |V3 - V2| < |V1 - V2|.

2. An imager as claimed in claim 1, **characterized in that** the region of the first conductivity type of the photodiode is connected to the input of a source follower circuit.

3. An imager as claimed in claim 2, **characterized in that** the source follower comprises a first field effect transistor having a gate which is connected to the input of the source follower and a drain to which, during operation, a DC voltage, for example, V2 is applied, and a source which is connected to an output of the source follower, the source follower further comprising a series arrangement of a selection transistor and a load between the junction point of the source of the first transistor and the output and a further junction point to which a fixed voltage, for example, V1 is applied during operation.

4. An imager as claimed in any one of the preceding claims, **characterized in that** the reset transistor is of the p-channel type and has a source in the form of a p-type zone which is connected in a conducting manner to the anode of the photodiode.

## Patentansprüche

1. Abbildungsvorrichtung mit einem Halbleiterkörper, dessen Oberfläche mit Bildaufnahmeelementen versehen ist, die jeweils eine Fotodiode mit einer Anode und einer Kathode umfassen und weiterhin einen Reset-Transistor mit einer Source-Zone und einer Drain-Zone eines ersten Leitfähigkeitstyps und einer Gate-Elektrode umfassen, die mit Mitteln zum Anlegen von Spannungen zum Ein- und Ausschalten des Transistors verbunden ist und wobei entweder die Source- oder die Drain-Zone mit entweder der Anoden- oder der Kathodenregion vom ersten Leitfähigkeitstyp der Fotodiode verbunden ist, deren andere Region vom entgegengesetzten, zweiten Leitfähigkeitstyp mit einem Verbindungspunkt verbunden ist, an den während des Betriebs eine Spannung V1 angelegt wird, und wobei die andere Region, entweder die Source- oder die Drain-Zone, des Transistors mit einem Verbindungspunkt verbunden ist, an den während des Betriebs eine von V1 abweichende Spannung V2 angelegt wird, wobei die Fotodiode zuerst während des Betriebs rückgesetzt wird, indem eine Spannung an die Gate-Elektrode angelegt wird, die den Transistor zum Einschalten veranlasst, und anschließend während einer nachfolgenden Integrationsperiode eine weitere Spannung V3 an die Gate-Elektrode angelegt wird, die den Transistor zum Ausschalten veranlasst, **dadurch gekennzeichnet, dass** der Pegel von V3 so gewählt wird, dass |V3 - V2| < |V1 - V2|.

2. Abbildungsvorrichtung nach Anspruch 1, **dadurch gekennzeichnet, dass** die Region des ersten Leitfähigkeitstyps der Fotodiode mit dem Eingang einer Source-Folger-Schaltung verbunden ist.

3. Abbildungsvorrichtung nach Anspruch 2, **dadurch gekennzeichnet, dass** der Source-Folger einen ersten Feldeffekttransistor mit einer Gate-Elektrode, die mit dem Eingang des Source-Folgers verbunden ist, und einer Drain-Elektrode, der während des Betriebs eine Gleichspannung, zum Beispiel V2, zugeführt wird, und einer Source-Elektrode, die mit einem Ausgang des Source-Folgers verbunden ist, umfasst, wobei der Source-Folger weiterhin eine Reihenanordnung aus einem Auswahltransistor und einer Last zwischen dem Verbindungspunkt der Source-Elektrode des ersten Transistors und dem Ausgang und einem weiteren Verbindungspunkt umfasst, dem während des Betriebs eine feste Spannung, zum Beispiel V1, zugeführt wird.

4. Abbildungsvorrichtung nach einem der vorhergehenden Ansprüche, **dadurch gekennzeichnet, dass** der Reset-Transistor vom p-Kanal-Typ ist und eine Source-Elektrode in Form einer p-Zone hat, die auf leitende Weise mit der Anode der Fotodiode verbunden ist.

## Revendications

1. Imageur comprenant un corps semi-conducteur dont une surface est pourvue d'éléments de prise d'image, chacun comprenant une photodiode avec une anode et une cathode et comprenant encore un transistor de remise à zéro avec une zone de source et une zone de drain d'un premier type de conductivité et une grille, laquelle grille est connectée à des moyens pour appliquer des tensions afin de mettre le transistor en état de conduction et hors d'état de conduction, et dans lequel une des zones de source et de drain est connectée à une des régions d'anode et de cathode du premier type de conductivité de la photodiode dont l'autre région du deuxième type opposé de conductivité est connectée à un point de jonction auquel une tension V1 est appliquée au cours du fonctionnement et dans lequel l'autre région des zones de source et de drain du transistor est connectée à un point de jonction auquel une tension V2 qui est différente de la tension V1 est appliquée au cours du fonctionnement, dans lequel la photodiode est d'abord remise à zéro au cours du fonctionnement par l'application d'une tension à la grille, ce qui effectue que le transistor est mis en état de conduction, après quoi une nouvelle autre tension V3 est appliquée à la grille au cours d'une période subséquente d'intégration, ce qui effectue que le transistor est mis hors d'état de conduction, **caractérisé en ce que** le niveau de la tension V3 est choisi de telle façon que |V3 - V2| < |V1 - V2|.

2. Imageur selon la revendication 1, **caractérisé en ce que** la région du premier type de conductivité de la photodiode est connectée à l'entrée d'un circuit suiveur de source.

3. Imageur selon la revendication 2, **caractérisé en ce que** le circuit suiveur de source comprend un premier transistor à effet de champ ayant une grille qui est connectée à l'entrée du circuit suiveur de source et à un drain auquel, au cours du fonctionnement, une tension continue, par exemple, V2 est appliquée, et une source qui est connectée à une sortie du circuit suiveur de source, le circuit suiveur de source comprenant encore un montage en série d'un transistor de sélection et une charge entre le point de jonction de la source du premier transistor et la sortie et un nouveau autre point de jonction auquel une tension fixe, par exemple, V1 est appliquée au cours du fonctionnement.

4. Imageur selon l'une quelconque des revendications précédentes 1 à 3, **caractérisé en ce que** le transistor de remise à zéro est du type à canal p et présente une source sous forme d'une zone du type p qui est connectée d'une manière conductrice à l'anode de la photodiode.
